# EUROPEAN PATENT SPECIFICATION

(11) **EP 0 450 760 B1**
(45) Date of publication and mention of the grant of the patent: **07.02.1996**
(21) Application number: 91301671.3
(22) Date of filing: 28.02.1991
(51) Int. Cl.: C23C 16/26, C23C 16/54

(54) **Process for the manufacture of ceramic fibres**
Verfahren zur Herstellung von keramischen Fasern
Procédé pour la fabrication de fibres céramiques

(30) Priority: 31.03.1990 GB 9007273
(43) Date of publication of application: 09.10.1991
(73) Proprietor: THE SECRETARY OF STATE FOR DEFENCE, Farnborough, Hampshire GU14 6TD (GB)
(72) Inventor: Griffin, Christopher James, Sunbury-on-Thames, Middlesex, TW16 7LN (GB); Moss, Renny Neil, Sunbury-on-Thames, Middlesex, TW16 7LN (GB)
(74) Representative: Russell, James

(56) References cited:
- GB-A- 2 031 954
- US-A- 3 130 073
- US-A- 3 177 094
- US-A- 4 863 760

## Description

This invention relates to a process for the manufacture of ceramic fibres.

It is well known to deposit ceramic coatings on filaments using chemical vapour deposition techniques. In a typical process, a filament is passed continuously through a deposition chamber containing gases which on contact with the hot filament deposit the desired coating. The filament is usually heated by passage of an electric current.

It is known to pass a filament through a deposition chamber comprising halogenated hydrocarbons. Typically, EP-A-353934 discloses a process for depositing a carbon coating on a fibre in which the fibre is contacted with at least one halogenated aliphatic hydrocarbon.

It is also known to pass a filament through a deposition chamber comprising hydrocarbons. Typically, JP-A-61219708 and JP-A-60145375 disclose the use of various gaseous hydrocarbons.

Surprisingly, we have found that if the deposition chamber comprises both a halogenated hydrocarbon and a hydrocarbon, a carbon coated filament is obtained which has improved qualities over the coated filaments of the known prior art.

Accordingly, the present invention provides a process for depositing a coating on a filament, which comprises heating the filament and passing the heated filament through a deposition chamber containing gases which on contact with the hot filament deposit the coating; characterised in that said gases comprise chloroform and a hydrocarbon having 1 to 6 carbon atoms, a carbon coating being produced.

Any suitable C(1-6) hydrocarbon may be used, for example propane or, especially, propene.

The gases in the deposition chamber may contain further components, for example an inert carrier gas such as argon or neon. Hydrogen may be present if desired, or the reaction may be carried out in the absence of hydrogen.

The volume ratio of chloroform to C(1-6) hydrocarbon may vary widely, but is preferably in the range of from 3:1 to 1:8, especially 2:1 to 1:4. If an inert carrier gas is used, the volume ratio of C(1-6) hydrocarbon to carrier gas is preferably in the range of from 1:6 to 1:40, especially 1:10 to 1:20.

The deposition chamber is preferably a vertical tube. It has been found that especially good results are obtained when the gas inlet is at the lower end of the tube and the outlet at the upper end.

The process according to the invention may be used for depositing a carbon coating on any desired filament. The filament may for example be tungsten, or carbon requiring a further carbon layer. Preferably however the filament is a ceramic filament, for example boron or, especially, silicon carbide. Such filaments are well known, and their manufacture described in many publications, for example US 4 127 659 and US 3 622 369.

In order to promote efficient deposition, the filament is preferably heated to a temperature in the range of from 800 to 1300°C, especially 900 to 1100°C. Most conveniently, the filament is heated by passage of an electric current supplied via two liquid metal electrodes through which the filament passes. These electrodes may contain pure mercury, or liquid metal mixtures selected from mercury/indium, mercury/cadmium or gallium/indium.

The filaments produced by the process of the invention are particularly useful for the preparation of titanium-based composites. Such composites may be prepared by embedding filaments in a matrix of titanium, titanium alloy or titanium intermetallic, under the action of heat.

Commercially available chloroform may be used to carry out the present invention. The chloroform may contain levels of impurities, eg alcohols which function as stabilising agents to prevent dissociation of the molecule during storage. Typical stabilising agents include ethanol and/or amylene (tertiary amyl alcohol); these are typically present in concentrations of 1-3% volume and 20-40 ppm respectively.

The present invention will now be described in greater detail:

### 1. General Method

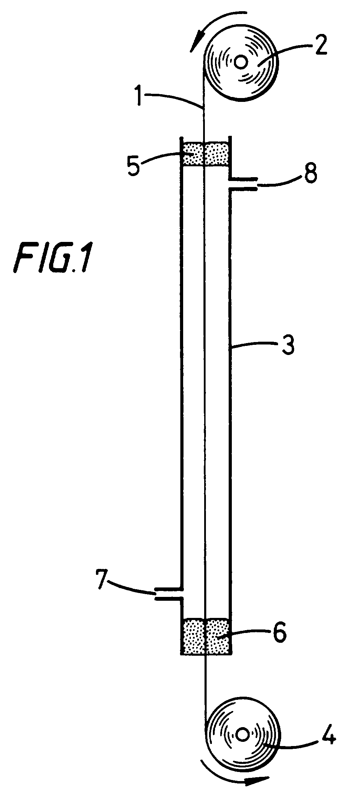

Figure 1, of the accompanying drawings, shows an apparatus which may be used to carry out the invention. A filament 1, for example silicon carbide with a tungsten core, is fed from a supply 2 via a tube 3 to a store 4. The filament 1 passes through mercury electrodes 5 and 6 at the ends of the tube 3. The electrodes 5 and 6 form part of an electric circuit (not shown) which supplies an electric heating current to the filament, raising it to a temperature typically of from 800 to 1100°C, eg 900 to 1100°C. Argon (flow rate 1000 to 2000 standard cubic centimeters per minute (sccm)), propene (flow rate 5 to 125 sccm) and commercial chloroform ex BDH containing 1-3% ethanol, (40 to 160 sccm eg 30 to 70 sccm) are fed into the tube 2 via inlet 7, and spent gases removed via outlet 8. Filament entering the store 4 has a high-quality carbon coating.

### 2. Tests

### Fibre Strength Test

The coated fibres were tensile tested over a 25 mm gauge length. Aluminium grips were used to clamp and protect the fibres during testing. Tension was applied and the resulting force which caused the fibre to break was recorded. The mean of ten tests was used to calculate the fibre strength.

### 3. Examples

### Comparative Example 1. Propene Only

The aforementioned procedure was carried out using propene only. Propene was fed into the deposition chamber under a flow rate of 200 cm³min⁻¹ and an argon flow rate of 1400 cm³min⁻¹. The filament was heated to 800-1100°C. It was not possible to identify a coating using scanning electron microscopy (SEM). A thin coating of 50nm was identified using secondary ion mass spectroscopy (SIMS).

### Comparative Example 2. Chloroform Only

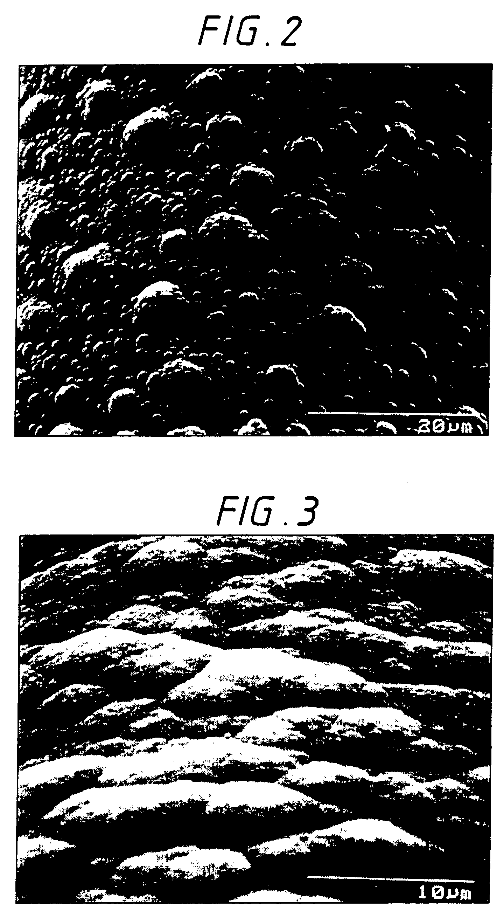

The procedure of Comparative Example 1 was repeated in the absence of propene but under a flow rate 80 cm³min⁻¹ of chloroform. The resulting coating is 0.8 µm in thickness and is shown in Figure 2. The coating is nodular in appearance, exhibits poor adhesion and gives a fibre strength of 3.33 GPa.

### Example 1. Propene and Chloroform

The procedure of Comparative Example 2 was repeated in the presence of propene (flow rate of 75 cm³min⁻¹). The resulting coating is 0.5 µm in thickness and is shown in Figure 3. The coating is visibly smoother than that obtained from using only chloroform, exhibits good adhesion and gives a fibre strength of 4.02 GPa.

## Claims

1. A process for depositing a coating on a filament, which comprises heating the filament and passing the heated filament through a deposition chamber containing gases which on contact with the hot filament deposit the coating; characterised in that said gases comprise chloroform and a hydrocarbon having 1 to 6 carbon atoms, a carbon coating being produced.

2. A process as claimed in claim 1, in which the C(1-6) hydrocarbon is propene.

3. A process as claimed in either claim 1 or claim 2, in which the volume ratio of chloroform to C(1-6) hydrocarbon is in the range of from 3:1 to 1:8.

4. A process as claimed in claim 3, in which the volume ratio of chloroform to C(1-6) hydrocarbon is in the range of from 2:1 to 1:4.

5. A process as claimed in any one of claims 1 to 4, in which the gases in the deposition chamber contain an inert carrier gas.

6. A process as claimed in any one of claims 1 to 5, in which the filament is heated to a temperature in the range of from 800 to 1300°C.

7. A process as claimed in claim 6, in which the filament is heated to a temperature in the range of from 900 to 1100°C.

8. A process as claimed in any one of claims 1 to 7, in which the deposition chamber is a vertical tube, the gas inlet is at the lower end of the tube and the gas outlet at the upper end.

9. A process as claimed in any one of claims 1 to 8, in which a carbon coating is deposited on a ceramic filament.

10. A process as claimed in claim 9, in which a carbon coating is deposited on a silicon carbide filament.

## Patentansprüche

1. Verfahren zum Abscheiden eines Überzugs auf einem Faden, das die Erhitzung des Fadens und das Durchleiten des erhitzten Fadens durch eine Abscheidungskammer vorsieht, die Gase enthält, die im Kontakt mit dem heißen Faden den Überzug abscheiden,
**dadurch gekennzeichnet,**
daß die Gase Chloroform und einen Kohlenwasserstoff mit 1 bis 6 Kohlenstoffatomen aufweisen, wobei ein Kohlenstoffüberzug erzeugt wird.

2. Verfahren nach Anspruch 1, bei dem der C(1-6)-Kohlenwasserstoff Propen ist.

3. Verfahren nach Anspruch 1 oder Anspruch 2, bei dem das Volumenverhältnis von Chloroform zu C(1-6)-Kohlenwasserstoff im Bereich von 3:1 bis 1:8 ist.

4. Verfahren nach Anspruch 3, bei dem das Volumenverhältnis von Chloroform zu C(1-6)-Kohlenwasserstoff im Bereich von 2:1 bis 1:4 ist.

5. Verfahren nach irgendeinem der Ansprüche 1 bis 4, bei dem die Gase in der Abscheidungskammer ein inertes Trägergas enthalten.

6. Verfahren nach irgendeinem der Ansprüche 1 bis 5, hei dem der Faden auf eine Temperatur im Bereich von 800 bis 1300 °C erhitzt wird.

7. Verfahren nach Anspruch 6, bei dem der Faden auf eine Temperatur im Bereich von 900 bis 1100 °C erhitzt wird.

8. Verfahren nach irgendeinem der Ansprüche 1 bis 7, bei dem die Abscheidungskammer ein vertikales Rohr ist, der Gaseinlaß am unteren Ende des Rohres ist und der Gasauslaß am oberen Ende ist.

9. Verfahren nach irgendeinem der Ansprüche 1 bis 8, bei dem ein Kohlenstoffüberzug auf einem keramischen Faden abgeschieden wird.

10. Verfahren nach Anspruch 9, bei dem ein Kohlenstoffüberzug auf einem Siliziumkarbidfaden abgeschieden wird.

## Revendications

1. Procédé pour déposer un revêtement sur un filament, qui comprend le chauffage du filament, et la soumission du filament chauffé à un passage par une chambre de dépôt contenant des gaz qui, lors de leur contact avec le filament chaud, déposent le revêtement, procédé caractérisé en ce que lesdits gaz comprennent du chloroforme et un hydrocarbure comportant 1 à 6 atomes de carbone, avec production d'un revêtement en carbone.

2. Procédé tel que revendiqué à la revendication 1, dans lequel l'hydrocarbure en C(1-6) est du propène.

3. Procédé tel que revendiqué dans l'une ou l'autre des revendications 1 ou 2, dans lequel le rapport volumétrique du chloroforme à l'hydrocarbure en C(1-6) se situe dans l'intervalle compris entre 3:1 et 1:8.

4. Procédé tel que revendiqué à la revendication 3, dans lequel le rapport volumétrique du chloroforme à l'hydrocarbure en C(1-6) se situe dans l'intervalle compris entre 2:1 et 1:4.

5. Procédé tel que revendiqué dans l'une quelconque des revendications 1 à 4, dans lequel les gaz présents dans la chambre de dépôt contiennent un véhicule gazeux inerte.

6. Procédé tel que revendiqué dans l'une quelconque des revendications 1 à 5, dans lequel le filament est chauffé jusqu'à une température comprise entre 800 et 1300°C.

7. Procédé tel que revendiqué à la revendication 6, dans lequel le filament est chauffé jusqu'à une température comprise entre 900 et 1100°C.

8. Procédé tel que revendiqué dans l'une quelconque des revendications 1 à 7, dans lequel la chambre de dépôt est un tube vertical, l'entrée de gaz se situe à l'extrémité inférieure du tube et la sortie de gaz à l'extrémité supérieure.

9. Procédé tel que revendiqué dans l'une quelconque des revendications 1 à 8, dans lequel le revêtement en carbone est déposé sur un filament céramique.

10. Procédé tel que revendiqué à la revendication 9, dans lequel un revêtement en carbone est déposé sur un filament en carbure de silicium.
